# EUROPEAN PATENT SPECIFICATION

(11) **EP 0 235 428 B1**
(45) Date of publication and mention of the grant of the patent: **26.05.1993**
(21) Application number: 86305226.2
(22) Date of filing: 07.07.1986
(51) Int. Cl.: G03F 1/00

(54) **Mounting preparation for optical membrane**
Montiersystem für optische Membranen
Système pour l'assemblage d'une membrane optique

(30) Priority: 05.03.1986 US 836490
(43) Date of publication of application: 09.09.1987
(73) Proprietor: YEN, Yung-Tsai, Los Altos, CA 94022 (US)
(72) Inventor: YEN, Yung-Tsai, Los Altos, CA 94022 (US)
(74) Representative: Kerr, Simonne June

## Description

This invention relates to a method for preparing a plural - layer optical membrane for adhesion mounting on a support frame, such as a ring.

In recent years, optical membranes called pellicles have played an important role in the manufacture of semiconductor wafers that are used in various integrated semiconductor circuits. As is well known by those skilled in the art, pellicles protect (against contamination) photo masks which are used in the various photolithography steps re - quired in wafer preparation.

The typical pellicle takes the form of an extremely thin optical membrane which is supported on (bonded to) a ring - like frame, the entirety of which is then placed over a wafer during photolithography. Obviously, it is important that the membrane be securely bonded to the frame so that it will function properly.

In some instances, the membrane is prepared with plural layers, for example to include, on what might be thought of as the mounting side of the membrane, an anti - reflective coating to improve optical transmissivity. In some of these instances, the layer structure thus prepared on the mounting side in a membrane has an adhesion affinity for a typical adhesive, such as any conventional 5- minute epoxy, which is lower than that of one or more of the immediately underlying layers. This lower affinity makes adhesion - bonding of the membrane to a support ring somewhat difficult, and sometimes subject to later failure.

Bonding to a support ring is also sometimes a problem where the adhesion between the multiple layers is not as good as it might be. Where such internal adhesion is weak, mounting a support ring to the outer-most layer could promote tearing away or cracking between the layers of a multi - layered membrane.

A general object of the present invention, accordingly, is to provide a unique mounting preparation technique which avoids such a bonding problem in a very practical and satisfactory man - ner.

According to a preferred method of practicing the invention, and having in mind the outline of the ring structure which is to become the membrane's support structure, a portion of the layer structure on the mounting side of the membrane is selectively removed to expose the better bonding capability of an underlying layer.

The invention will now be described further, by way of example, with reference to the accom - panying drawings, in which
Fig. 1 is a simplified, fragmentary elevation il - lustrating application of the technique of the invention to a three-layer optical membrane, where selective layer removal takes place in two of the three layers.
Fig. 2 is similar to Fig. 1, except that it illustrates application of the invention to remove but one of the three layers in the same kind of optical membrane.
Fig. 3 is a view on a much smaller scale, in plan, showing a support ring, with a small portion removed, bonded to the mounting side in an optical membrane, such as the membranes shown in Figs. 1 and 2.

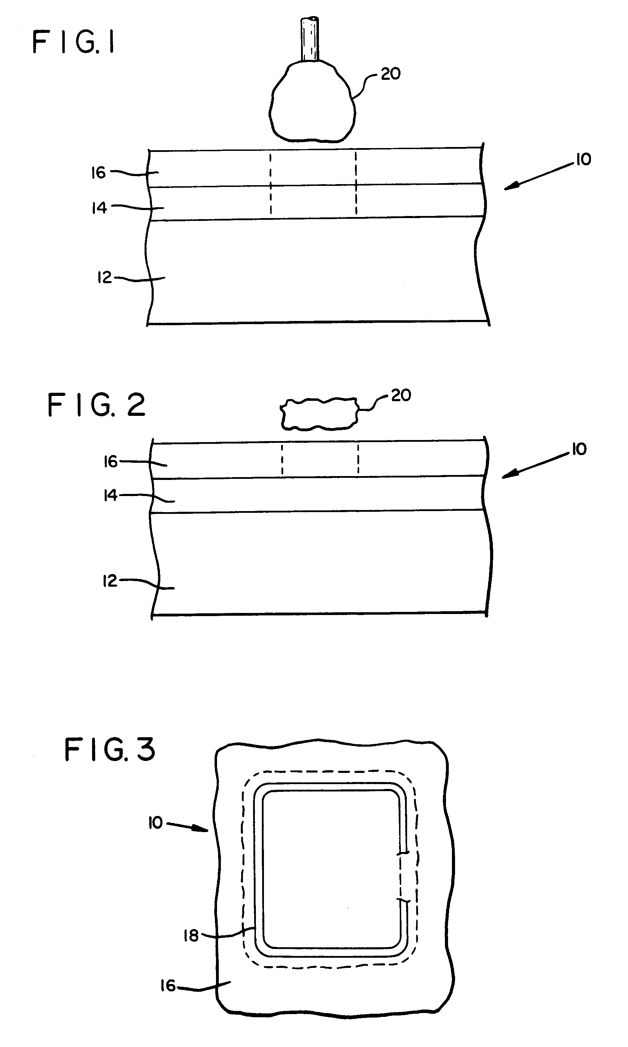

Turning now to the drawings, and referring first of all to Fig. 1, indicated generally at 10 is an optical membrane which is to become part of a pellicle. Membrane 10 includes a base layer, also referred to herein as a second layer structure, 12, an intermediate, or inner, layer 14, and thereabove (in Fig. 1) an outer layer 16. Layers 14, 16 herein are also referred to collectively as a first layer structure.

In the membrane now being described, layer 12, which has a thickness of about 2.8-microns, is formed of nitrocellulose. Layer 14, which has a thickness of about 700-Angstroms is formed of an organic polymer, such as polyvinylnaphthalene. Layer 16, which collectively with layer 14 forms an anti - reflective coating for the membrane on the membrane's mounting side, is formed of an organic fluorocarbon compound, prepared as follows.

1000 - ml of a product made by the Minnesota Mining and Manufacturing Company (3M), known as FC-721 was concentrated to 200 - ml by low pressure evaporation. 1800 - ml of another 3M product known as FC - 77 was added to the con - centrate. After filtration, the resulting 2000 - ml mixture was ready for application, as by spin casting, to layer 14.

In the assembly of membrane 10 with a support ring to form a final pellicle, it is intended that the chosen ring be bonded adhesively on the mounting side of the membrane, which, in membrane 10, is the upper side thereof in Fig. 1. In the case now being described, the particular ring to which bonding is to occur has a somewhat rectan - gular outline, and is illustrated at 18 in Fig. 3.

Because of the specific material characteristics of layers 12, 14, 16, it turns out that layer 12 has a higher adhesion affinity for the above-indicated kind of adhesive than layer 14, and that layer 14 has a higher adhesion affinity than layer 16. Accordingly, bonding of the ring to the membrane will be most secure with the bond occurring on the face of layer 12, slightly less secure with bonding occurring on the face of layer 14, and even less secure with bonding occurring on the face of layer 16.

Following the method of the present invention, and according to one way of practicing the same, portions of layers 14, 16 are removed, as will be explained, to enable bonding on the face of layer 12. According to another way of practicing the invention, a portion of layer 16 only is removed to enable bonding on the face of layer 14.

Still with reference to Fig. 1, with knowledge of the mounting outline of ring 18, and using a suitable guide template, a first step takes place with the solvent - removal of a pattern in layer 16 which substantially matches the outline and configuration of ring 18. This is done preferably by guiding a suitable device, such as cotton-tipped wand, about such a template, with the wetted tip applying an appropriate solvent, like that described above, in a controlled path which thus removes material from layer 16 in the desired pattern. Such a wand is shown generally at 20 in Fig. 1.

The next step in the practice of the invention with regard to what is shown in Fig. 1, is passage of the wand along the same path to apply another appropriate solvent, toluene in the case of poly - vinylnaphthalene, to remove, essentially, a match - ing pattern from the material in layer 14. What results after this operation is that there exists a pattern of removed material, indicated by the dashed lines in Fig. 1, in layers 14, 16, which pattern, on the inside, substantially exactly matches the inside outline of ring 18. Thus, the upper surface of layer 12 in Fig. 1 is properly exposed for adhesion to the ring. One should note that, in the patterned removal of material from layers 14, 16, care need only be taken to assure that the inside outline thereof substantially exactly matches the inside outline of ring 18. Control over the outside outline is unnecessary since, ultimately, the expanse of the membrane outside the perimeter of the ring will be removed.

Shifting attention for a moment to Fig. 3, here ring 18 is shown in a condition bonded to layer 12. Where a portion of the ring has been removed, the dashed lines indicate the trough of removed materials in layers 14, 16.

Fig. 2 illustrates another way of practicing the invention where material is removed only from layer 16 to enable the ring to be bonded to layer 14. Obviously, this is performed by making a pass of the wand over the upper surface of the mem - brane in the manner described for the first step outlined above in connection with preparation of the membrane in Fig. 1. This pass of the wand removes material only from layer 16, and such is indicated by the dashed lines in Fig. 2.

Thus, there is proposed by the invention a unique and very simple technique to maximise bonding between a support ring and a pellicle membrane in instances where a plural - layer membrane has, on its mounting side, a relatively poor adhesion capability.

## Claims

1. A method of preparing a plural - layer optical membrane for adhesion mounting on a support frame having an inside mounting outline, where the membrane has a mounting side formed with a first layer structure which overlies a second layer structure, characterized in that a portion of such first layer structure is removed from the membrane's mounting side in a pattern substantially matching the frame's inside mounting outline and by such removal expos - ing, substantially in the shape of such pattern, an expanse of the underlaying layer.

2. A method according to claim 1, characterized in that the removal is accomplished by solvent application to such first layer structure.

3. A method according to claim 1 or 2, characterized in that the first layer structure in - cludes outer and inner layers.

4. A method according to claim 3, characterized in that a portion of the inner layer in the first layer structure is removed in a pattern corresponding to the removed portion of the outer layer.

5. A method according to claim 4, characterized in that the removal of the inner layer is accomplished by solvent application to the inner layer.

6. A method according to claim 5, characterized in that the removal steps are accomplished by applying a solvent - soaked wand to the portions to be removed.

## Patentansprüche

1. Verfahren zum Aufbereiten einer optischen Mehrschichtmembran zum Verkleben mit ei - nem ein inneres Verklebeprofil aufweisenden Tragrahmen, wobei die Membran eine Verkle - beseite aufweist, die von einer ersten, eine zweite Schichtstruktur überlagernden Schichtstruktur gebildet wird, dadurch gekennzeichnet, daß ein Teilbereich einer solchen ersten Schichtstruktur von der verklebeseite der Membran in einem Muster abgetragen wird, das im wesentlichen dem inneren Verklebeprofil des Rahmens entspricht, und daß durch ein solches Abtragen ein Flächenbereich der darunterliegenden Schicht freigelegt wird, der im wesentlichen die Ausbildung eines solchen Musters aufweist.

2. Verfahren gemäß Anspruch 1, dadurch gekennzeichnet, daß das Abtragen durch Aufbringen eines Lösungsmittels auf besagte erste Schichtstruktur bewerkstelligt wird.

3. Verfahren gemäß Anspruch 1 oder 2, dadurch gekennzeichnet, daß die erste Schichtstruktur eine äußere und eine innere Schicht enthält.

4. Verfahren gemäß Anspruch 3, dadurch gekennzeichnet, daß ein Teilbereich der inneren Schicht in der ersten Schichtstruktur in einem Muster abgetragen wird, das dem abgetragenen Teilbereich der äußeren Schicht entspricht.

5. Verfahren gemäß Anspruch 4, dadurch gekennzeichnet, daß das Abtragen der inneren Schicht durch Aufbringen eines Lösungsmittels auf die innere Schicht bewerkstelligt wird.

6. Verfahren gemäß Anspruch 5, dadurch gekennzeichnet, daß der Abtragevorgang durch Aufbringen eines mit Lösungsmittel getränkten Tupfers auf die zu entfernenden Teilbereiche bewerkstelligt wird.

## Revendications

1. Méthode pour préparer une membrane optique multicouche destinée à être montée par adhérence sur une armature de support pré - sentant un profil de montage intérieur, selon laquelle la membrane possède une face de montage formée par une première structure formant couche qui recouvre une seconde structure formant couche, caractérisée en ce qu'une partie de ladite première structure formant couche est enlevée de la face de mon - tage de la membrane suivant un motif corres - pondant sensiblement au profil de montage intérieur de l'armature et par le fait que cet enlèvement expose, sensiblement suivant la forme dudit motif, une étendue de la couche sous-jacente.

2. Méthode selon la revendication 1, caractérisée en ce que l'enlèvement est réalisé par appli - cation d'un solvant à ladite première structure formant couche.

3. Méthode selon la revendication 1 ou 2, carac - térisée en ce que la première structure formant couche comporte des couches extérieure et intérieure.

4. Méthode selon la revendication 3, caractérisée en ce qu'une partie de la couche intérieure de la première structure formant couche est en - levée suivant un motif correspondant à la partie enlevée de la couche extérieure.

5. Méthode selon la revendication 4, caractérisée en ce que l'enlèvement de la couche intérieure est réalisé par application d'un solvant à la couche intérieure.

6. Méthode selon la revendication 5, caractérisée en ce que les étapes d'enlèvement sont réali - sées par application d'une baguette trempée dans un solvant aux parties à enlever.
